# FASCICULE DE BREVET EUROPEEN

(11) **EP 2 600 429 B1**
(45) Date de publication et mention de la délivrance du brevet: **24.06.2015**
(21) Numéro de dépôt: 12193728.8
(22) Date de dépôt: 22.11.2012
(51) Int. Cl.: H01L 41/113, H01L 41/338, H01L 41/43, H02N 2/18

(54) **Capteur d'énergie vibratoire utilisant une céramique piézoélectrique**
Schwingungsenergiesammler mit einem piezoelektrischen Keramikelement
Vibrational energy harvester using a piezoelectric ceramic part

(30) Priorité: 02.12.2011 FR 1161108
(43) Date de publication de la demande: 05.06.2013
(73) Titulaire: Université de Valenciennes et du Hainaut-Cambresis, 59313 Valenciennes Cedex 9 (FR)
(72) Inventeur: Rguiti, Mohamed, 59600 MAUBEUGE (FR); D'Astorg, Sophie, 59300 VALENCIENNES (FR); Courtois, Christian, 59570 GUSSIGNIES (FR)
(74) Mandataire: Lefevre-Groboillot, David André

(56) Documents cités:
- JP-A- 9 211 151
- JP-A- 2006 216 578
- US-A1- 2010 084 947
- AKTAKKA E E ET AL: "Energy scavenging from insect flight", JOURNAL OF MICROMECHANICS & MICROENGINEERING, vol. 21, no. 9, 12 août 2011 (2011-08-12), pages 095016/1-11, XP020210115, ISSN: 0960-1317, DOI: 10.1088/0960-1317/21/9/095016
- CHOI W J ET AL: "Energy harvesting MEMS device based on thin film piezoelectric cantilevers", JOURNAL OF ELECTROCERAMICS, vol. 17, no. 2-4, décembre 2006 (2006-12), pages 543-548, XP019465962, ISSN: 1385-3449

## Description

### Domaine technique et art antérieur

L'invention s'inscrit dans le domaine des capteurs d'énergie vibratoire et des convertisseurs d'énergie vibratoire en énergie électrique utilisant une céramique piézoélectrique.

La piézoélectricité est la propriété que possèdent certains matériaux de se polariser électriquement sous l'action d'une contrainte mécanique. Ces matériaux sont donc capables de convertir la contrainte qu'ils subissent, qui peut être par exemple une vibration, en charges électriques.

Parmi les matériaux piézoélectriques connus, les céramiques ont un rendement électromécanique très élevé par rapport aux autres matériaux. Elles font donc l'objet d'attentions particulières pour les applications industrielles.

Une application potentielle importante des céramiques piézoélectriques se situe dans la fabrication de générateurs d'électricité de petite taille pouvant être intégrés dans tout type de dispositifs électroniques portables, comme les téléphones ou les assistants numériques personnels.

De tels générateurs fonctionnant grâce aux vibrations extérieures, par exemple générées par la marche ou les mouvements du porteur, présentent un grand intérêt, puisqu'ils sont autonomes et ont une durée de vie potentiellement illimitée, sans nécessiter l'utilisation de recharges.

Outre les dispositifs électroniques portables, de tels générateurs peuvent être utilisés dans des dispositifs électroniques fixes, comme les réseaux de capteurs à transmission sans fil, et des systèmes électroniques de contrôle, devant fonctionner de manière autonome sur le plan électrique. Il suffit qu'une source de vibrations soit présente, comme le vent, la frappe des doigts sur le clavier d'un ordinateur, ou le trafic routier à proximité d'une chaussée. On peut aussi vouloir récupérer l'énergie de vibrations dans les véhicules et dans les appareils de sport pour l'alimentation de leur électronique intégrée.

La mise au point de tels générateurs se heurte néanmoins à différentes difficultés. En particulier, l'élément piézoélectrique doit avoir des caractéristiques adaptées spécialement pour capter l'énergie de ces vibrations. Il est généralement avancé que les fréquences de ces vibrations sont essentiellement basses (quelques dizaines à quelques centaines de Hertz)

Le document US 2010/0084947 enseigne ainsi de former un capteur d'énergie par utilisation d'un film de céramique, formé soit par une technique de déposition de couche mince soit par une technique d'impression. La mise en place d'une masse en extrémité de l'élément piézoélectrique permet en général d'obtenir de bonnes performances. Mais si le dispositif est de taille micrométrique, il est enseigné d'utiliser une forme de spirale pour étendre la longueur de l'élément piézoélectrique tout en conservant un capteur d'encombrement limité.

Le document DE 102004056754, qui divulgue une structure présentant quelques ressemblances avec la précédente, n'aborde quant à lui pas le problème de la récupération d'énergie de vibrations. Il s'intéresse à des actionneurs piézoélectriques plans comprenant nécessairement deux couches de matériaux reliées entre elles. Il aborde le problème de permettre une déflection puissante de l'élément piézoélectrique perpendiculairement à son plan tout en conservant des dimensions extérieures faibles, ce qui est nécessaire pour pouvoir intégrer l'actionneur dans le dispositif à actionner, qui peut être un interrupteur ou une soupape. Il enseigne pour cela de joindre par des faces planes, un support avec un élément piézoélectrique, puis de couper celui-ci en forme de spirales ou de méandres. Alternativement, l'élément piézoélectrique peut être coupé avant d'être collé, ou formé dans la forme adaptée. Une utilisation de la structure en tant que capteur est également évoquée, mais il n'est pas indiqué ce que le dispositif pourrait capter.

Dans ce contexte, la présente invention vise à fournir une solution pour mettre au point des capteurs d'énergie vibratoire et des convertisseurs d'énergie vibratoire en énergie électrique qui soient performants, peu coûteux et de fabrication aisée. Un tel capteur ou convertisseur est du type basé sur une langue de céramique piézoélectrique ayant au repos un développement sur un plan selon une géométrie compacte, ce qui permet de réduire au maximum l'encombrement du système.

### Résumé de l'invention

Pour améliorer la facilité de fabrication et la performance, il est proposé un procédé de fabrication d'un capteur d'énergie vibratoire comprenant une langue de céramique piézoélectrique ayant au repos un développement sur un plan selon une géométrie compacte, comprenant une étape de coulage en bande puis cuisson d'une couche de ladite céramique piézoélectrique, puis une étape de découpe de ladite couche pour délimiter ladite langue.

Le coulage en bande permet de déposer une couche de la céramique sur une grande largeur (jusqu'à 20 cm). Il a été constaté que quand une langue de céramique piézoélectrique ayant au repos un développement sur un plan selon une géométrie compacte est préparée dans une telle couche, elle est capable une fois métallisée et polarisée, de capter l'énergie de vibrations de l'environnement courant avec un excellent rendement énergétique.

Il est avancé que cet effet vient du fait que la langue de céramique piézoélectrique, taillée dans une telle couche en bénéficiant d'un carré par exemple de 20 cm de côté, et bénéficiant donc d'une longueur importante, a une fréquence de résonnance proche des fréquences des vibrations de l'environnement courant.

De plus, le, coulage en bande permet le dépôt de couches fines (jusqu'à 200 µm voire moins), ce qui donne accès à des structures présentant des performances accrues.

Le coulage en bande permet également le dépôt de couches ne nécessitant pas d'être déposées ou reportées sur un support, et qui offrent également des performances améliorées pour cette raison.

Le coulage en bande a déjà été proposé pour la fabrication de pièces en matériaux céramiques piézoélectriques comme les antennes de sonar, dans le document FR 2861066. Mais ce document enseigne de déformer la bande avant de la cuire, et ne s'intéresse pas à des structures comprenant une langue de céramique piézoélectrique ayant au repos un développement sur un plan selon une géométrie compacte. Il ne permet aucunement d'anticiper les avantages qu'il y a à préparer une telle structure à l'aide d'un procédé de coulage de bande, avantages présentés ci-dessus.

Le procédé selon l'invention peut par ailleurs comprendre avantageusement une étape de découpe de la couche par laser pour délimiter la langue.

Avantageusement, la géométrie compacte comprend au moins une spirale, ou avantageusement au moins deux spirales positionnées l'une par rapport à l'autre de manière compacte, par exemple en étant placées de manière concentriques.

Cela présente l'avantage de permettre une meilleure capture ou conversion de l'énergie vibratoire. Il est avancé que cet effet proviendrait d'un élargissement de la gamme de fréquences de vibrations auquel le capteur ou convertisseur a accès.

Avantageusement, le procédé comprend au moins deux étapes distinctes de coulage en bande, chaque étape de coulage menant à la formation d'une couche de céramique piézoélectrique dans un empilement de couches.

Le procédé peut comprendre au moins une étape de dépôt d'une électrode d'or ou d'argent sur une face de ladite couche. Ces métaux sont avantageux car ils constituent de bons conducteurs.

L'invention propose aussi un capteur d'énergie vibratoire comprenant une langue de céramique piézoélectrique ayant au repos un développement sur un plan selon une géométrie compacte, **caractérisé en ce qu'il** est fabriqué selon un procédé tel que présenté.

Avantageusement, la géométrie compacte comprend trois spirales concentriques.

Avantageusement, le capteur comprend au moins deux langues de céramique piézoélectrique ayant au repos un développement sur un plan selon une géométrie compacte, chaque langue étant entourée d'électrodes, lesdites langues étant montées en série ou en parallèle pour cumuler les puissances dégagées par chacune d'entre elles.

L'invention propose aussi un convertisseur d'énergie vibratoire en énergie électrique comprenant un capteur tel que présenté.

### Brève description des figures

La figure 1 présente un convertisseur d'énergie selon l'art antérieur.
La figure 2 présente un autre convertisseur d'énergie selon l'art antérieur.
Les figures 3 et 4 présentent un premier mode de réalisation d'un capteur d'énergie selon l'invention.
Les figures 5 et 6 présentent un deuxième mode de réalisation d'un capteur d'énergie selon l'invention.
La figure 7 présente un mode de réalisation d'un procédé selon l'invention de fabrication d'un capteur d'énergie.
Les figures 8 et 9 présentent deux autres modes de réalisation d'un convertisseur d'énergie selon l'invention.

### Exposé détaillé de l'invention

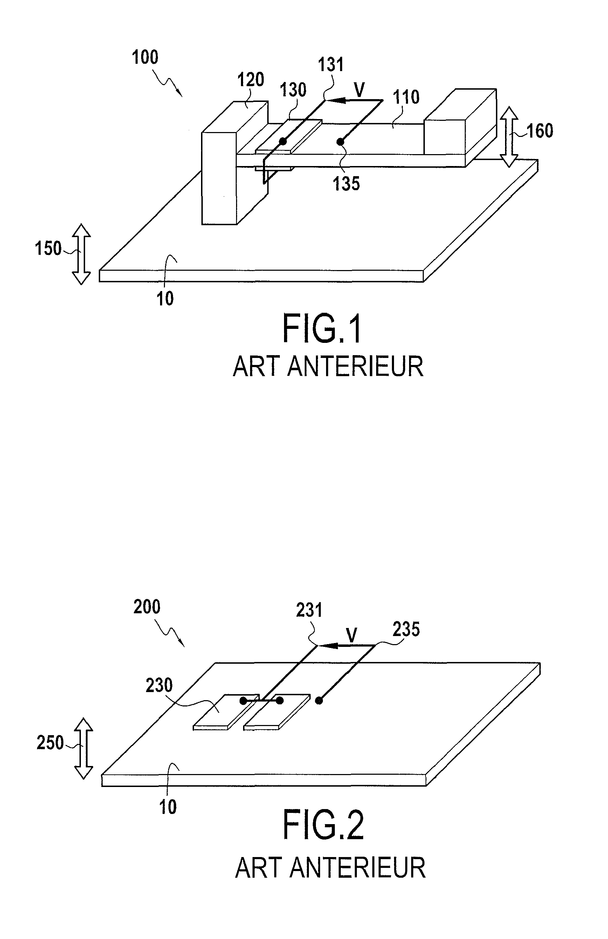

En figure 1, on a représenté un convertisseur 100 selon l'art antérieur disposé sur un support 10 plat. Le convertisseur 100 comprend une poutre 110 fixée par une de ses extrémités perpendiculairement à un mat 120 s'élevant quant à lui perpendiculairement à la surface du support 10. La poutre 110 est maintenue sur toute sa longueur à distance de la surface du support 10.

La poutre est lestée en sa deuxième extrémité d'une masse dite masse sismique, qui constitue avec elle un oscillateur dont la fréquence de résonance est ajustée par la valeur de la masse et la longueur de la poutre. Le support 10 subit des oscillations suivant la flèche 150, qui induisent des oscillations de l'extrémité de la poutre comportant la masse sismique dans le sens de la flèche 160.

Des éléments piézoélectriques 130 sont collés sur la poutre. Un élément piézoélectrique rectangulaire est placé sur la face inférieure, et un autre sur la face supérieure. Une électrode relie les deux éléments. Des électrodes 131 et 135 placées respectivement sur les éléments piézoélectriques et la poutre permettent de récupérer l'énergie électrique générées par les éléments 130.

En figure 2, un autre convertisseur selon l'art antérieur, référencé 200 est représentée. Il est également placé sur un support 10 plat. Deux éléments piézoélectriques 230 rectangulaires sont collés directement sur la surface du support 10, l'un à côté de l'autre. Une électrode relie les deux éléments. Des électrodes 231 et 235 placées respectivement sur les éléments piézoélectriques et le support permettent de récupérer l'énergie électrique générée par les éléments 230. Le support 10 subit une flexion provoquée par des oscillations suivant la flèche 250.

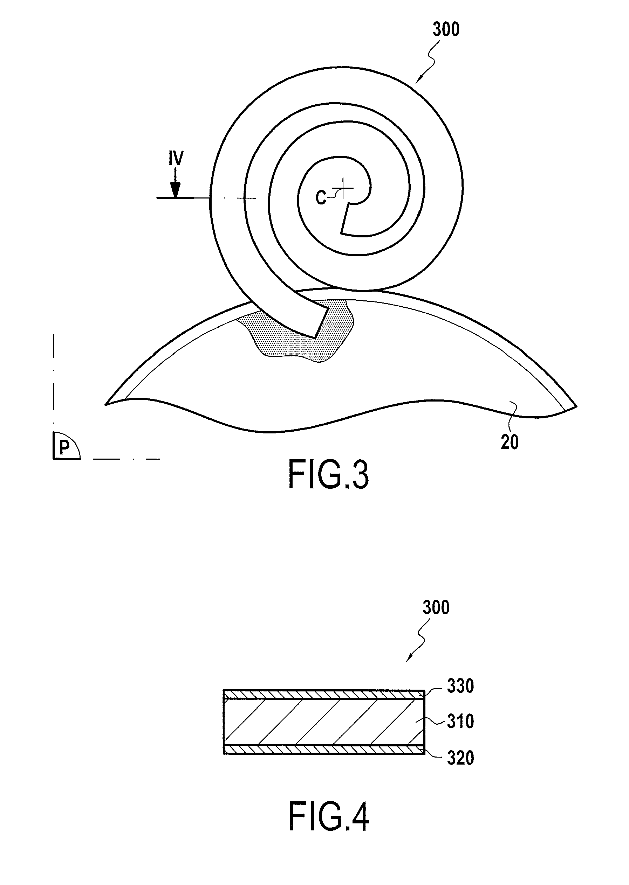

En figure 3, on a représenté un capteur piézoélectrique selon un mode de réalisation de l'invention.

Une langue 300 s'étend au repos dans un plan P sous la forme d'une spirale, s'étendant autour d'un centre. Celle-ci fait dans le mode de réalisation représentée 2 tours mais elle pourrait en faire moins ou plus. Un nombre de tours non entier est possible, dans certains modes de réalisation. La langue est métallisée sur ses deux faces, comme cela est représenté en figure 4, qui est une vue en coupe selon les repères 4 - 4 de la figure 3. On y voit la langue centrale de matériau piézoélectrique 310, entre des couches métalliques 320 et 330.

La langue 300 est fixée par de la colle sur un support. Elle a ici une largeur constante sur toute sa longueur, mais la largeur pourrait varier. Il est simplement nécessaire que la longueur soit bien supérieure à la largeur en tout point.

L'épaisseur (perpendiculairement au plan P) peut être soit inférieure à la largeur (mesurée dans le plan P), soit au plus égale à celle-ci. Par exemple, la longueur peut être de 10 à 200 mm, l'épaisseur de 0.1 à 1 mm, et la largeur de 1 à 10 mm. La surface occupée, définie par le contour extérieur de la langue 300 peut être d'environ 25 mm² à environ 100 cm².

La spirale représentée en figure 3 est une spirale sans angle, présentant une courbure sur toute sa longueur, cette courbure variant progressivement. Il pourrait néanmoins s'agir, dans une variante, d'une spirale présentant des angles, par exemple des angles entre lesquels la section est formée de sections sans courbure.

Le mode de réalisation de la figure 3 peut être modifié pour introduire une deuxième spirale en série avec la première : dans cette variante, une deuxième spirale occupe la partie vide entre les enroulements de la spirale représentée en figure 3.

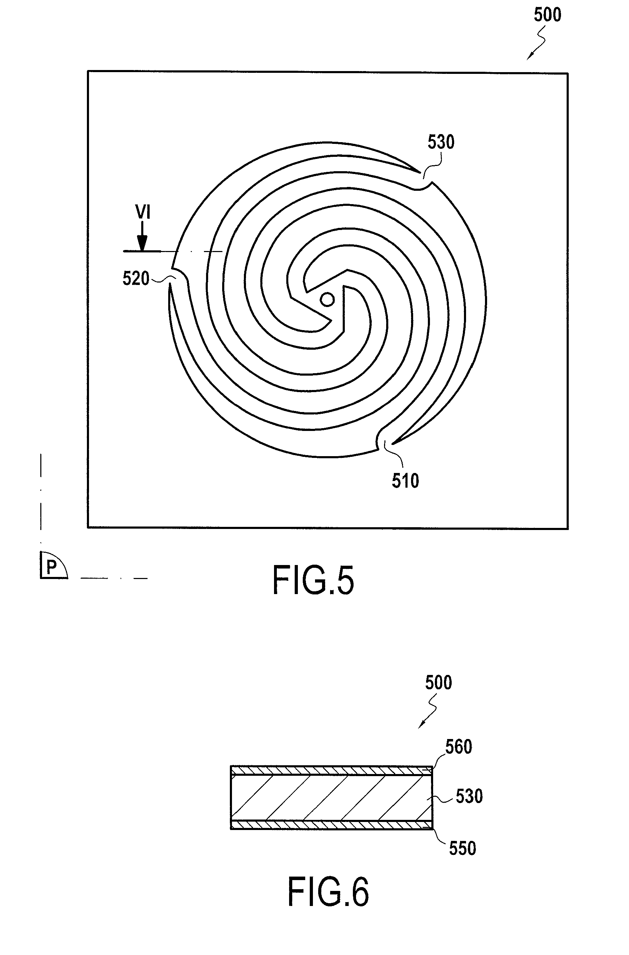

En figure 5, on a représenté un capteur piézoélectrique 500 selon un deuxième mode de réalisation de l'invention.

Le capteur 500 est constitué d'une plaque carrée de matériau piézoélectrique qui a été évidée de part en part perpendiculairement à son plan sur des surfaces définies par des formes fermées.

L'évidement a laissé subsister trois langues 510, 520 et 530 qui s'étendent au repos dans le plan P de la plaque sous la forme chacune d'une spirale. Celles-ci font chacune dans le mode de réalisation représenté1unique tour mais elles pourraient en faire moins ou plus, et chaque langue pourrait avoir un nombre de tours différent du nombre de tours des autres langues.

Les trois langues débutent à proximité du centre du capteur 500 et sont accrochées les unes aux autres par une structure centrale en forme de triangle, chaque langue débutant à un sommet du triangle. En variante, le triangle est remplacé par un carré et le nombre de langues est de quatre, ou un polygone à n côtés (régulier ou irrégulier), et le nombre de langues est de n.

Les trois langues s'achèvent, à distance du centre, en rejoignant la partie périphérique non évidée de la plaque carrée. La largeur de chaque bande est suffisante pour que la langue soit maintenue à la plaque à son extrémité.

La partie périphérique de la plaque ainsi que les langues sont métallisées sur leurs deux faces, comme cela est représenté en figure 6, qui est une vue en coupe selon les repères 6 - 6 de la figure 5. On y voit une langue 530 de matériau piézoélectrique 310, entre des couches métalliques 550 et 560.

Les commentaires faits en relation avec la figure 3 sont valables en ce qui concerne la figure 5, en particulier en ce qui concerne la forme de la spirale, ou les rapports entre les dimensions des langues. Les trois langues peuvent de plus avoir des caractéristiques différentes les unes des autres.

A la place d'une forme en spirale, une langue ayant une forme compacte en méandres (sinuosités prononcées et serrées occupant une grande partie d'une surface donnée) peut être utilisée.

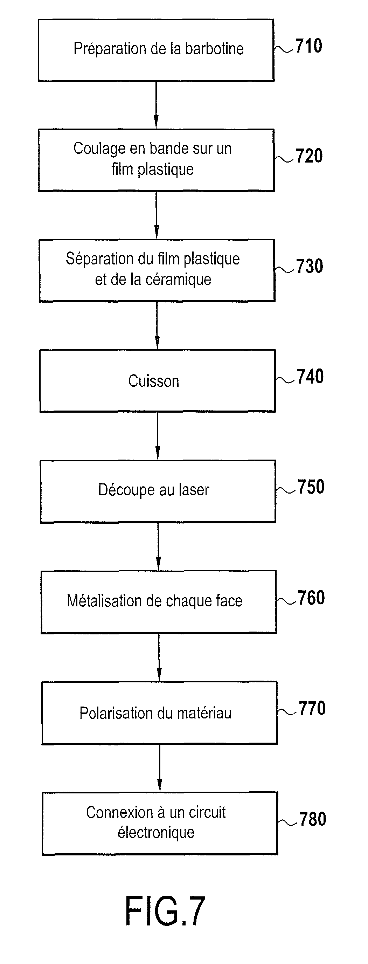

En figure 7, on a représenté les étapes d'un procédé de fabrication de capteurs ou de convertisseurs selon l'invention.

Au cours d'une étape 710, on prépare la barbotine, c'est-à-dire que l'on prépare un mélange de poudre céramique, de solvant, de dispersant, de liant et de plastifiant en phase organique ou aqueuse ressemblant à une soupe.

Au cours d'une étape 720, on coule la barbotine sur un film plastique, par la technique de coulage en bande. On obtient ainsi une couche ou bande constituant un composite céramique non cuite / polymère, qui est à ce stade facilement déformable. Le coulage du film se fait à une vitesse et un débit contrôlés, ce qui permet de contrôler l'épaisseur du film.

Au cours d'une étape 730, on sépare le film plastique de la céramique, puis au cours d'une étape 740, on transforme le composite en céramique par cuisson induisant un frittage.

La partie organique du mélange, quand une telle partie est présente, brule. On obtient ainsi une plaque céramique dont les propriétés mécaniques permettent de la tailler par laser.

Au cours d'une étape 750, on effectue alors une découpe laser de la plaque, pour lui donner la forme décrite en relation avec la figure 3 ou la figure 5, par exemple. La découpe se fait en délimitant des surfaces pleines qui sont ensuite enlevées, résultant en une structure telle que celles représentées en figures 3 et 5, où la compacité est élevée car les spirales sont serrées, mais où des espaces vides sont présents entre les différentes portions voisines des spirales.

Alternativement, la découpe laser peut se faire sans enlever de surfaces, en constituant un sillon dans la matière de manière à désolidariser localement les unes des autres des portions voisines de la couche, jusqu'à ce que la couche constitue une langue compacte serrée, les frottements entre portions voisines étant suffisamment faibles pour qu'elles soient désolidarisées dans les conditions opératoires.

Des techniques de découpe alternatives au laser peuvent aussi être utilisées.

Au cours d'une étape 760, on effectue alors la métallisation de chacune des deux faces, séparément, avec un dépôt d'argent ou d'or, par exemple. Il s'agit là de déposer les électrodes 320, 330 ou 550, 560 sur les faces respectives de l'élément piézoélectrique.

Au cours d'une étape 770, on effectue la polarisation de la céramique cuite entre les deux électrodes, de manière à lui conférer ses propriétés piézoélectriques. Cela est effectué par application d'un champ électrique très élevé.

Alternativement, on peut effectuer l'ensemble formé des étapes 760 de métallisation et 770 de polarisation, dans cet ordre, avant l'étape 750 de découpe, la coupe s'effectuant à la fois dans le matériau piézoélectrique et le métal.

On peut aussi effectuer les étapes dans l'ordre, métallisation, puis découpe, puis polarisation.

Enfin au cours d'une étape 780, on relit les électrodes à un circuit électronique comprenant au moins un redresseur de tension et au moins une capacité pour stocker l'énergie électrique récupérée.

Dans une variante du procédé, entre les étapes 730 de séparation du film plastique et de la céramique et 740 de cuisson ou frittage, on réalise un empilement de couches céramiques et métalliques alternées, comprenant au moins deux couches de céramique piézoélectrique. Des couches d'autres natures chimiques et physiques peuvent être intercalées. Les céramiques utilisées dans les différentes couches de céramique peuvent être identiques ou différentes.

L'utilisation du capteur selon l'invention implique sa mise en place sur un support, préférentiellement dans un boîtier protecteur, de telle sorte que les vibrations dont l'énergie doit être captée soient transmises au capteur via le support, et que ces vibrations soient orientées majoritairement suivant la direction perpendiculaire au plan P.

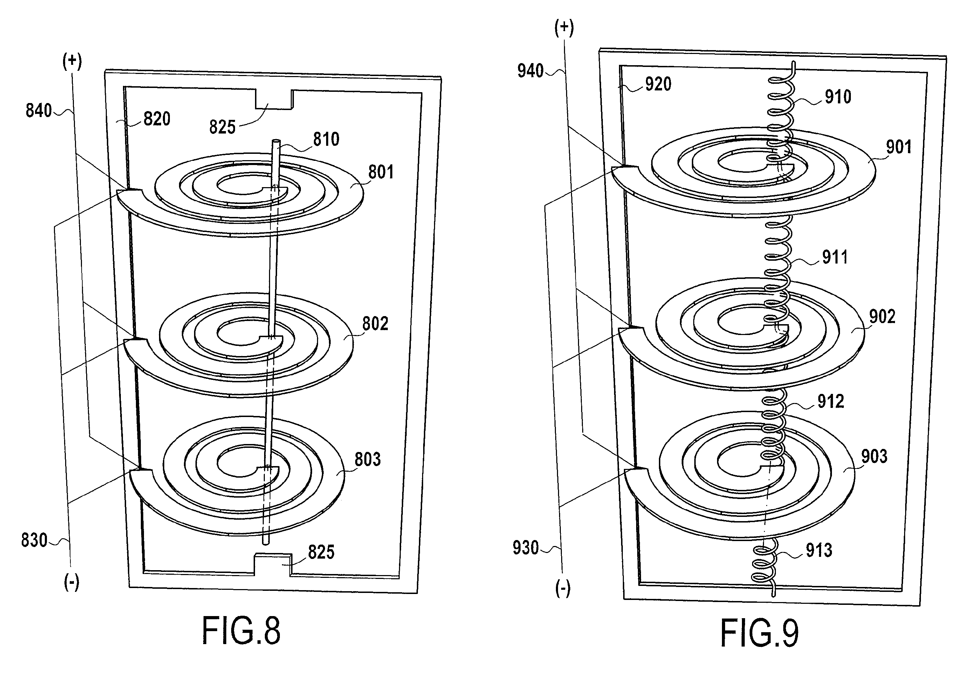

Aux figures 8 et 9 on a représenté deux modes de montage de capteurs selon l'invention. Trois spirales recouvertes sur leurs faces d'électrodes sont montées en parallèle et reliées à des bornes positives et négatives 840 et 830. Elles pourraient alternativement être montées en série. Ces montages permettent de cumuler les énergies récupérées par les différentes spirales.

Dans le cas du montage de la figure 8, l'extrémité externe de chaque spirale est fixée à un cadre support 820 qui est lui-même fixé sur une source de vibration (vélo, voiture, machine, corps humain....). L'autre extrémité de chaque spirale est attachée à un lien rigide 810 libre par ailleurs qui oscille sous l'effet des vibrations de la source de vibration. Le mouvement de l'élément 810 entraîne la flexion des différentes spirales en phase. La tension et le courant récupérés sont redressés, additionnés puis stockés et/ou directement utilisés. Des butées rigides 825 sont présentes pour limiter le mouvement du lien rigide 810 en cas de trop fortes vibrations. Ces butées pourraient être remplacées par des ressorts faisant office d'amortisseur.

Dans le cas du montage de la figure 9, qui dérive de celui de la figure 8, des ressorts 911 et 912 indépendants l'un de l'autre sont fixés entre les extrémités internes des spirales adjacentes 901 et 902, puis 902 et 903. Des ressorts 910 et 913 sont également fixés entre les spirales extérieures 901 et 903 et le cadre support 920. Les vibrations des différentes spirales ne sont ici pas forcément en phase. Les différentes spirales peuvent donc avoir des fréquences propres différentes ce qui permet d'élargir le spectre fréquentiel - ou bande passante - du dispositif proposé et donc permet d'exploiter au mieux l'énergie de sources de vibrations vibrant à plusieurs fréquences (spectre discontinu) ou de sources caractérisées par un spectre fréquentiel à large bande (spectre continu).

Dans les deux cas, le nombre de spirales est quelconque (pas nécessairement trois comme présenté sur les deux figures), les dimensions des spirales peuvent être identiques ou différentes, l'extrémité interne de chaque spirale peut être chargé par une masse sismique qui peut être la même pour toutes les spirales ou être différente d'une spirale à l'autre.

Les raideurs des différents ressorts (dans le montage de la figure 9), la masse du lien rigide 810 (dans le montage de la figure 8) ainsi que les valeurs des éventuelles masses sismiques sont optimisées de telle façon que l'amplitude maximale de vibration ne dépasse pas la limite d'endommagement des spirales en céramique lors du fonctionnement. Comme déjà mentionné, des butées peuvent être ajoutées pour ne pas dépasser cette limite critique.

Les montages présentés en figures 8 et 9, ainsi que les structures à plusieurs spirales comme celle de la figure 5, peuvent être construits avec des matériaux piézoélectriques différents des céramiques, par exemple des polymères, des cristaux ou des composites.

L'invention ne se limite pas aux modes de réalisation représentés et décrits mais s'étend à toutes les variantes dans la portée des revendications.

## Revendications

1. Procédé de fabrication d'un capteur d'énergie vibratoire (300 ; 500) comprenant une langue de céramique piézoélectrique (310 ; 510 ; 801, 802, 803 ; 901, 902, 903) ayant au repos un développement sur un plan (P) selon une géométrie compacte, comprenant une étape de coulage en bande (720) d'une couche de ladite céramique piézoélectrique, puis une cuisson de ladite couche puis une étape de découpe (750) de ladite couche pour délimiter ladite langue.

2. Procédé selon la revendication 1, l'étape de découpe (750) de la couche étant effectuée par laser.

3. Procédé selon la revendication 1 ou la revendication 2, **caractérisé en ce que** la géométrie compacte comprend au moins une spirale.

4. Procédé selon la revendication précédente, **caractérisé en ce que** la géométrie compacte comprend au moins deux spirales concentriques.

5. Procédé selon l'une des revendications précédentes, comprenant au moins deux étapes distinctes de coulage en bande, chaque étape de coulage menant à la formation d'une couche de céramique piézoélectrique dans un empilement de couches dans lequel est incluse une électrode interne.

6. Procédé selon l'une des revendications précédentes, comprenant au moins une étape de dépôt (760) d'une électrode d'or ou d'argent sur une face de ladite couche.

7. Capteur d'énergie vibratoire (300 ; 500 ; Fig. 8 ; Fig. 9) comprenant une langue de céramique piézoélectrique (310 ; 510 ; 801, 802, 803 ; 901, 902, 903) ayant au repos un développement sur un plan (P) selon une géométrie compacte, **caractérisé en ce qu'il** est fabriqué selon un procédé selon l'une des revendications 1 à 6.

8. Capteur selon la revendication 7, **caractérisé en ce que** la géométrie compacte comprend trois spirales concentriques.

9. Capteur selon l'une des revendications de capteur précédentes, comprenant au moins deux langues de céramique piézoélectrique (801, 802, 803 ; 901, 902, 903) ayant au repos un développement sur un plan (P) selon une géométrie compacte, chaque langue étant entourée d'électrodes, lesdites langues étant montées en série ou en parallèle pour cumuler les puissances dégagées par chacune d'entre elles.

10. Convertisseur d'énergie vibratoire en énergie électrique comprenant un capteur (300 ; 500 ; Fig. 8 ; Fig. 9) selon l'une des revendications de capteur précédentes.

## Patentansprüche

1. Verfahren zur Herstellung eines Schwingungsenergiesensors (30; 500), umfassend eine piezoelektrische Keramikzunge (310; 510; 801, 802, 803; 901, 902, 903), die in Ruhestellung auf einer Ebene (P) eine Entwicklung gemäß einer kompakten Geometrie hat, umfassend einen Schritt des Bandgießens (720) einer Schicht der piezoelektrischen Keramik, dann ein Brennen der Schicht, dann einen Schritt des Ausschneidens (750) der Schicht, um die Zunge zu begrenzen.

2. Verfahren nach Anspruch 1, wobei der Schritt des Ausschneidens (750) der Schicht durch Laser erfolgt.

3. Verfahren nach Anspruch 1 oder Anspruch 2, **dadurch gekennzeichnet, dass** die kompakte Geometrie mindestens eine Spirale umfasst.

4. Verfahren nach dem vorhergehenden Anspruch, **dadurch gekennzeichnet, dass** die kompakte Geometrie mindestens zwei konzentrische Spiralen umfasst.

5. Verfahren nach einem der vorhergehenden Ansprüche, umfassend mindestens zwei getrennte Schritte des Bandgießens, wobei jeder Gießschritt zur Bildung einer piezoelektrischen Keramikschicht in einer Stapelung von Schichten führt, in die eine interne Elektrode eingeschlossen ist.

6. Verfahren nach einem der vorhergehenden Ansprüche, umfassend mindestens einen Schritt des Aufbringens (760) einer Elektrode aus Gold oder Silber auf eine Seite der Schicht.

7. Schwingungsenergiesensor (300; 500; Fig. 8; Fig. 9), umfassend eine piezoelektrische Keramikzunge (310; 510; 801, 802, 803; 901, 902, 903), die in Ruhestellung auf einer Ebene (P) eine Entwicklung gemäß einer kompakten Geometrie hat, **dadurch gekennzeichnet, dass** er nach einem Verfahren nach einem der Ansprüche 1 bis 6 hergestellt ist.

8. Sensor nach Anspruch 7, **dadurch gekennzeichnet, dass** die kompakte Geometrie drei konzentrische Spiralen umfasst.

9. Sensor nach einem der vorhergehenden Ansprüche für den Sensor, umfassend mindestens zwei piezoelektrische Keramikzungen (801, 802, 803; 901, 902, 903), die in Ruhestellung auf einer Ebene (P) eine Entwicklung gemäß einer kompakten Geometrie haben, wobei jede Zunge von Elektroden umgeben ist, wobei die Zungen in Serie oder parallel montiert sind, um die von jeder von ihnen freigesetzten Leistungen zu kumulieren.

10. Wandler einer Schwindungsenergie in elektrische Energie, umfassend einen Sensor (300; 500; Fig. 8; Fig. 9) nach einem der vorhergehenden Ansprüche für den Sensor.

## Claims

1. A method for manufacturing a vibratory energy sensor (300; 500) comprising a piezoelectric ceramic strip (310; 510; 801, 802, 803; 901, 902, 903) having at rest an expansion on a plane (P) according to a compact geometry, comprising a step (720) for tape casting a layer of said piezoelectric ceramic, and then baking said layer and then a step (750) for cutting out said layer in order to delimit said strip.

2. The method according to claim 1, the step (750) for cutting out the layer being carried out by a laser.

3. The method according to claim 1 or claim 2, **characterized in that** the compact geometry comprises at least one spiral.

4. The method according to the preceding claim, **characterized in that** the compact geometry comprises at least two concentric spirals.

5. The method according to one of the preceding claims, comprising at least two distinct tape casting steps, each casting step leading to the formation of a piezoelectric ceramic layer in a stack of layers in which an internal electrode is included.

6. The method according to one of the preceding claims, comprising at least one step (760) for depositing a gold or silver electrode on one face of said layer.

7. A vibratory energy sensor (300; 500; Fig. 8; Fig. 9) comprising a piezoelectric ceramic strip (310; 510; 801, 802, 803; 901, 902, 903) having at rest an expansion on a plane (P) according to a compact geometry, **characterized in that** it is manufactured in accordance with a method according to one of claims 1 to 6.

8. The sensor according to claim 7, **characterized in that** the compact geometry comprises three concentric spirals.

9. The sensor according to one of the preceding sensor claims, comprising at least two piezoelectric ceramic strips (801, 802, 803; 901, 902, 903) having at rest an expansion on a plane (P) according to a compact geometry, each strip being surrounded by electrodes, said strips being mounted in series or in parallel in order to accumulate the powers emitted by each of them.

10. A converter of vibratory energy into electric energy comprising a sensor (300; 500; Fig. 8; Fig. 9) according to one of the preceding sensor claims.
